# EUROPÄISCHE PATENTSCHRIFT

(11) **EP 3 309 864 B1**
(45) Veröffentlichungstag und Bekanntmachung des Hinweises auf die Patenterteilung: **09.03.2022**
(21) Anmeldenummer: 17202855.7
(22) Anmeldetag: 11.05.2012
(51) Int. Cl.: H01M 10/42, H01M 10/48, H01M 50/271, G01R 31/36

(54) **LEITUNGSSYSTEM ZUM VERBINDEN EINER MEHRZAHL VON SPANNUNGSABGRIFFSTELLEN UND/ODER TEMPERATURMESSSTELLEN EINER ELEKTROCHEMISCHEN VORRICHTUNG MIT EINER ÜBERWACHUNGSEINHEIT**
LINE SYSTEM FOR CONNECTING A NUMBER OF POWER PICK-UP POINTS AND/OR TEMPERATURE MEASUREMENT POINTS OF AN ELECTROCHEMICAL DEVICE WITH A MONITORING UNIT
SYSTÈME DE CONDUITE DESTINÉ À RACCORDER UNE MULTITUDE DE PRISES DE DÉRIVATION DE TENSION ET/OU DE PRISES DE MESURE DE TEMPÉRATURE D'UN DISPOSITIF ÉLECTROCHIMIQUE DOTÉ D'UNE UNITÉ DE SURVEILLANCE

(30) Priorität: 01.06.2011 DE 102011076888
(43) Veröffentlichungstag der Anmeldung: 18.04.2018
(62) Teilanmeldung aus: 12167729.8
(73) Patentinhaber: ElringKlinger AG, 72581 Dettingen (DE)
(72) Erfinder: Laderer, Mark, 72582 Grabenstetten (DE); Diez, Armin, 73252 Lenningen (DE); Groshert, Jan, 72581 Dettingen/Erms (DE); Kohnle, Michael, 72584 Hülben (DE); Fritz, Wolfgang, 72555 Metzingen (DE); Tamegger, Christoph, 72661 Grafenberg (DE); Müller, Matthias, 72793 Pfullingen (DE)
(74) Vertreter: Hoeger, Stellrecht & Partner Patentanwälte mbB

(56) Entgegenhaltungen:
- EP-A2- 1 058 332
- WO-A1-2009/022521
- DE-A1-102009 033 044
- DE-A1-102010 035 114
- US-A1- 2002 098 734
- US-A1- 2009 274 952

## Beschreibung

Die vorliegende Erfindung betrifft eine elektrochemische Vorrichtung, umfassend ein Leitungssystem zum Verbinden einer Mehrzahl von Spannungsabgriffstellen und/oder Temperaturmessstellen der elektrochemischen Vorrichtung mit einer Überwachungseinheit der elektrochemischen Vorrichtung.

Bei elektrochemischen Vorrichtungen, insbesondere Akkumulatoren, ist im Betrieb der jeweiligen elektrochemischen Vorrichtung eine Überwachung der elektrochemischen Zellen im Hinblick auf die jeweilige elektrische Spannung und Temperatur erforderlich.

Bei bekannten elektrochemischen Vorrichtungen wird die elektrische Spannung über eine metallische Anbindung an einem Zellverbinder, welcher Zellterminals verschiedener elektrochemischer Zellen der elektrochemischen Vorrichtung miteinander verbindet, über eine Leiterplatine, direkt über eine Leiterplatine oder über einzelne Litzen abgegriffen.

Solche Leitungssysteme zur Verbindung von Spannungsmessstellen mit einer Überwachungseinheit der elektrochemischen Vorrichtung sind sehr aufwendig in der Montage, weisen einen sehr starren Aufbau auf, durch welchen keine Flexibilität in der Verbindung zwischen den elektrochemischen Zellen und der Überwachungseinheit möglich ist, und sind nur für eingeschränkte Materialkombinationen verwendbar.

Die US 2009/274952 A1 und die EP 1 058 332 A2 offenbaren elektrochemische Vorrichtungen gemäß dem Oberbegriff von Anspruch 1.

Die DE 10 2009 033 044 A1 offenbart eine elektrochemische Vorrichtung mit einem Leitungssystem, welches Aufnahmekanäle umfasst, die einstückig mit einem Trägerelement ausgebildet sind, welches Zellverbinder der elektrochemischen Vorrichtung trägt.

Die WO 2009/022521 A1 offenbart eine elektrochemische Vorrichtung mit einem Leitungssystem, welches Aufnahmekanäle umfasst, die an einer vertikal ausgerichteten Gehäusewand vorgesehen sind, während ein horizontal ausgerichtetes Trägerelement die Zellverbinder der elektrochemischen Vorrichtung trägt.

Die US 2002/098734 A1 offenbart eine elektrochemische Vorrichtung mit einem Leitungssystem, welches in eine Verbindungsplatte eingegossene Spannungsabgriffsleitungen umfasst.

Die DE 10 2010 035 114 A1 offenbart eine elektrochemische Vorrichtung mit einem horizontal ausgerichteten Trägerelement, welches Zellverbinder trägt, während die Aufnahmekanäle eines Leitungssystems an einer vertikal ausgerichteten Gehäusewand vorgesehen sind.

Der vorliegenden Erfindung liegt die Aufgabe zugrunde, eine einfach und schnell montierbare Verbindung zwischen Messstellen einer elektrochemischen Vorrichtung und einer Überwachungseinheit der elektrochemischen Vorrichtung herstellen zu können.

Diese Aufgabe wird durch eine elektrochemische Vorrichtung nach Anspruch 1 gelöst.

Das Leitungssystem ermöglicht eine einfache und schnelle Montage der Spannungsabgriffsleitungen bzw. Temperaturmessleitungen an der elektrochemischen Vorrichtung sowie eine einfache und schnelle Verbindung von Spannungsabgriffstellen bzw. Temperaturmessstellen der elektrochemischen Vorrichtung mit den Spannungsabgriffsleitungen bzw. Temperaturmessleitungen des Leitungssystems.

Durch den Einsatz von einzelnen Spannungsabgriffsleitungen und/oder Temperaturmessleitungen kann jede Position der elektrochemischen Vorrichtung gezielt für den Spannungs- bzw. Temperaturabgriff angefahren werden.

In dem Leitungssystem können unterschiedlichste Materialien miteinander verbunden werden.

Das Leitungssystem weist eine sehr hohe Flexibilität hinsichtlich der Verbindung zwischen der Mehrzahl von Spannungsabgriffstellen und/oder Temperaturmessstellen und der Überwachungseinheit der elektrochemischen Vorrichtung auf.

Besonders günstig ist es, wenn eine Temperaturüberwachung in das Leitungssystem integriert ist, indem das Leitungssystem Temperaturmessleitungen umfasst.

Das Leitungssystem ermöglicht eine flexible Verbindung zwischen den Spannungsabgriffstellen bzw. Temperaturmessstellen der elektrochemischen Vorrichtung einerseits und der Überwachungseinheit der elektrochemischen Vorrichtung andererseits.

Insbesondere können mittels des Leitungssystems auch große Distanzen zwischen den Spannungsabgriffstellen bzw. Temperaturmessstellen und der Überwachungseinheit einfach und kostengünstig überwunden werden.

Die Spannungsabgriffsleitungen und/oder Temperaturmessleitungen des Leitungssystems können einen Kabelbaum bilden.

Der Kabelbaum weist durch die Versteifungsstruktur zumindest abschnittsweise eine Formstabilität auf.

Die Versteifungsstruktur ist zumindest zeitweise mit den Spannungsabgriffsleitungen und/oder den Temperaturmessleitungen des Leitungssystems verbunden. Die Versteifungsstruktur kann nach dem Kontaktieren dieser Leitungen mit den jeweiligen Messstellen in dem Leitungssystem verbleiben; es ist aber auch denkbar, dass die Versteifungsstruktur nur als Montagehilfe dient und nach dem Kontaktieren der Leitungen mit den jeweiligen Messstellen von den Spannungsabgriffsleitungen und/oder den Temperaturmessleitungen gelöst und aus dem Leitungssystem entfernt wird.

Um eine hohe Flexibilität bei der Montage der elektrochemischen Vorrichtung zu ermöglichen, ist es günstig, wenn mindestens eine der Spannungsabgriffsleitungen und/oder mindestens eine der Temperaturmessleitungen des Leitungssystems einen Messstellenabschnitt umfasst, der an eine Spannungsabgriffstelle oder an eine Temperaturmessstelle anschließbar ist und außerhalb der Versteifungsstruktur angeordnet ist.

Ferner umfasst das Leitungssystem vorzugsweise einen mehrpoligen Stecker, der mit mehreren Spannungsabgriffsleitungen und/oder Temperaturmessleitungen des Leitungssystems verbunden ist und an den eine zu der Überwachungseinheit der elektrochemischen Vorrichtung führende, vorzugsweise mehrpolige, Verbindungsleitung anschließbar ist.

Vorzugsweise umfasst das Leitungssystem mindestens einen Temperatursensor, der vorzugsweise an mindestens eine Temperaturmessleitung angeschlossen ist. Ein solcher Temperatursensor kann beispielsweise als ein NTC-("Negative Temperature Coefficient")-Element ausgebildet sein.

Bei einer bevorzugten Ausgestaltung der Erfindung ist vorgesehen, dass die Versteifungsstruktur lösbar mit den Spannungsabgriffsleitungen und/oder den Temperaturmessleitungen des Leitungssystems verbunden ist.

Insbesondere kann vorgesehen sein, dass die Versteifungsstruktur lediglich als Montagehilfe oder Hilfsrahmen dient und wieder aus der elektrochemischen Vorrichtung entfernt wird, sobald die Spannungsabgriffsleitungen bzw. Temperaturmessleitungen mit den Spannungsabgriffstellen bzw. Temperaturmessstellen der elektrochemischen Vorrichtung kontaktiert worden sind.

Die Versteifungsstruktur umfasst mindestens einen Aufnahmekanal zum Einlegen mindestens einer Spannungsabgriffsleitung und/oder mindestens einer Temperaturmessleitung.

Besonders günstig ist es, wenn der gesamte Kabelbaum aus Spannungsabgriffsleitungen und/oder Temperaturmessleitungen als Ganzes in einen oder mehrere Aufnahmekanäle der Versteifungsstruktur des Leitungssystems einlegbar und an der Versteifungsstruktur fixierbar ist. In diesem Fall ist das Herstellungsverfahren des Leitungssystems besonders gut automatisierbar.

Der Kabelbaum kann an der Versteifungsstruktur durch einen Deckel oder durch Haltevorrichtungen wie beispielsweise Clipse oder Kabelbinder fixiert sein.

Die Versteifungsstruktur umfasst vorzugsweise mindestens eine Verzweigungsstelle, an welcher zwei oder mehrere Aufnahmekanäle miteinander verbunden sind.

Insbesondere kann vorgesehen sein, dass die Versteifungsstruktur mindestens einen Hauptaufnahmekanal umfasst, von welchem ein oder mehrere Nebenaufnahmekanäle abzweigen.

Das Leitungssystem kann einen Verschlussdeckel zum zumindest teilweisen Verschließen zumindest eines Aufnahmekanals der Versteifungsstruktur umfassen. Auf diese Weise ist es möglich, in die Versteifungsstruktur eingebrachte Spannungsabgriffsleitungen und/oder Temperaturmessleitungen zumindest zeitweise an der Versteifungsstruktur festzuhalten.

Ferner kann das Leitungssystem mindestens eine Halteeinrichtung umfassen, durch welche mindestens eine Spannungsabgriffsleitung und/oder mindestens eine Temperaturmessleitung an der Versteifungsstruktur, vorzugsweise lösbar, festlegbar ist.

Die Versteifungsstruktur kann ein spritzgießfähiges Material, insbesondere ein thermoplastisches Kunststoffmaterial, umfassen. Insbesondere kann die Versteifungsstruktur im Wesentlichen vollständig aus einem spritzgießfähigen, insbesondere thermoplastischen, Material gebildet sein.

Als Material für die Versteifungsstruktur kommen insbesondere PBT (Polybutylenterephthalat), PP (Polypropylen), PA (Polyamid), ABS (AcrylnitrilButadien-Styrol) und/oder LCP ("Liquid Crystal Polymer") in Betracht.

Die Versteifungsstruktur kann beispielsweise ein Spritzgießteil umfassen.

Alternativ oder ergänzend hierzu kann vorgesehen sein, dass die Versteifungsstruktur ein metallisches Umformteil, beispielsweise aus Aluminium, umfasst.

Ein solches Umformteil kann beispielsweise als ein Stanz-Biegeteil und/oder als eine Schiene mit U-förmigen Profil ausgebildet sein.

Alternativ oder ergänzend hierzu kann vorgesehen sein, dass die Versteifungsstruktur eine an Abschnitte von Spannungsabgriffsleitungen und/oder an Abschnitte von Temperaturmessleitungen angeformte Umhüllung umfasst.

Das Material der Umhüllung kann insbesondere ein Kunststoffmaterial, insbesondere ein Elastomermaterial, umfassen.

Vorzugsweise ist die Umhüllung im Wesentlichen vollständig aus einem Kunststoffmaterial, insbesondere aus einem Elastomermaterial, gebildet.

Die Umhüllung kann insbesondere durch Umspritzen an die Abschnitte von Spannungsabgriffsleitungen und/oder die Abschnitte von Temperaturmessleitungen angeformt sein.

Durch eine solche Umhüllung bleibt das Leitungssystem flexibel, lässt sich aber dennoch gut bei der Montage der elektrochemischen Vorrichtung handhaben.

Bei einer bevorzugten Ausgestaltung der elektrochemischen Vorrichtung ist vorgesehen, dass die elektrochemische Vorrichtung ferner mindestens einen Zellverbinder zum elektrisch leitenden Verbinden eines ersten Zellterminals einer ersten elektrochemischen Zelle und eines zweiten Zellterminals einer zweiten elektrochemischen Zelle umfasst, wobei mindestens eine Spannungsabgriffsleitung und/oder mindestens eine Temperaturmessleitung des Leitungssystems mit mindestens einem Zellverbinder verbunden ist.

Um eine unbeabsichtigte Berührung von Funktionselementen der elektrochemischen Vorrichtung, insbesondere von Zellverbindern oder Stromanschlüssen, zu verhindern, umfasst die elektrochemische Vorrichtung einen Deckel, der ein den elektrochemischen Zellen der elektrochemischen Vorrichtungen zugewandtes Trägerelement und ein den elektrochemischen Zellen der elektrochemischen Vorrichtung abgewandtes Abdeckelement umfasst, wobei das Leitungssystem zwischen dem Trägerelement und dem Abdeckelement angeordnet ist.

Insbesondere kann mindestens ein Leitungssystem durch eine geeignete Haltevorrichtung, vorzugsweise lösbar, an dem Trägerelement des Deckels festgelegt sein. In diesem Fall bilden das Trägerelement und das mindestens eine Leitungssystem eine vormontierte Baugruppe, welche während der Montage der elektrochemischen Vorrichtung als Einheit handhabbar ist.

Besonders günstig ist es dabei, wenn auch mindestens ein Zellverbinder der elektrochemischen Vorrichtung an dem Trägerelement des Deckels gehalten ist.

Unter einem "Deckel" für eine elektrochemische Vorrichtung ist in dieser Beschreibung und in den beigefügten Ansprüchen jedes Element zu verstehen, das zur Abdeckung zumindest eines Teils der elektrochemischen Vorrichtung vorgesehen ist. Bei dem abgedeckten Teil kann es sich dabei insbesondere um ein elektrochemisches Modul der elektrochemischen Vorrichtung oder aber auch nur um einen Teil eines elektrochemischen Moduls handeln.

Die elektrochemische Vorrichtung mit dem Leitungssystem kann insbesondere als ein Akkumulator, beispielsweise als ein Lithium-Ionen-Akkumulator, ausgebildet sein.

Wenn die erfindungsgemäße elektrochemische Vorrichtung als ein Akkumulator ausgebildet ist, eignet sie sich insbesondere als eine hoch belastbare Energiequelle, beispielsweise für den Antrieb von Kraftfahrzeugen.

Weitere Merkmale und Vorteile der Erfindung sind Gegenstand der nachfolgenden Beschreibung und der zeichnerischen Darstellung von Ausführungsbeispielen.

In den Zeichnungen zeigen:
- Fig. 1: eine schematische perspektivische Darstellung eines Akkumulatormoduls mit einem Gehäuse, in dem mehrere elektrochemische Zellen angeordnet sind und das durch einen Deckel verschlossen ist, welcher ein Trägerelement und ein mit dem Trägerelement verbundenes Abdeckelement umfasst.
- Fig. 2: eine schematische perspektivische Explosionsdarstellung des Akkumulatormoduls aus Fig. 1, in welcher das Gehäuse des Akkumulatormoduls mit den darin angeordneten elektrochemischen Zellen, das Trägerelement mit daran angeordneten Zellverbindern, Leitungssysteme zum Verbinden von Spannungsabgriffstellen und Temperaturmessstellen der Zellverbinder mit mehrpoligen Anschlusssteckern und das Abdeckelement getrennt dargestellt sind;
- Fig. 3: eine schematische perspektivische Darstellung des Trägerelements mit daran angeordneten Zellverbindern und daran angeordneten Leitungssystemen zum Verbinden von Spannungsabgriffstellen und Temperaturmessstellen der Zellverbinder mit den mehrpoligen Anschlusssteckern;
- Fig. 4: eine schematische perspektivische Darstellung einer zweiten Ausführungsform eines Leitungssystems mit Verzweigungsstellen, von denen sich Nebenaufnahmekanäle in einander entgegengesetzte Richtungen von einem Hauptaufnahmekanal des Leitungssystems weg erstrecken;
- Fig. 5: eine schematische perspektivische Darstellung einer dritten Ausführungsform eines Leitungssystems mit Verzweigungsstellen, an denen sich jeweils nur ein Nebenaufnahmekanal von einem Hauptaufnahmekanal des Leitungssystems weg erstreckt; und
- Fig. 6: eine schematische perspektivische Darstellung einer vierten Ausführungsform eines Leitungssystems, bei dem Spannungsabgriffsleitungen und/oder Temperaturmessleitungen in eine an die Leitungen angeformte Ummantelung eingehüllt sind.

Gleiche oder funktional äquivalente Elemente sind in allen Figuren mit denselben Bezugszeichen bezeichnet.

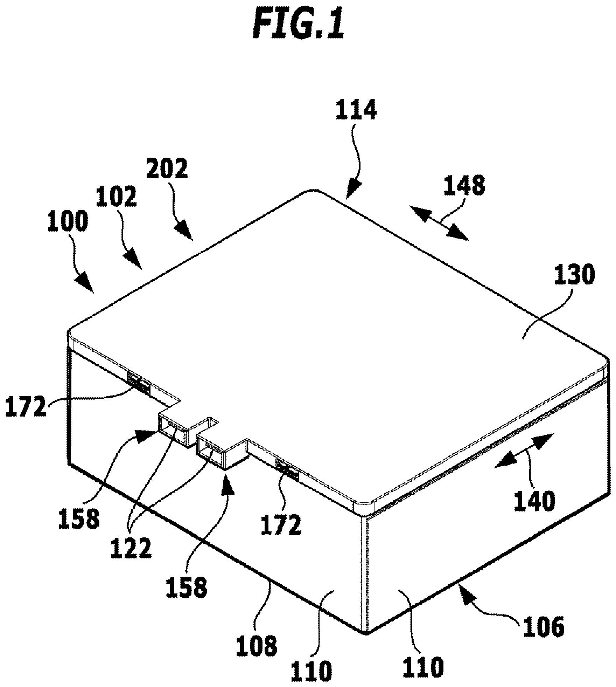

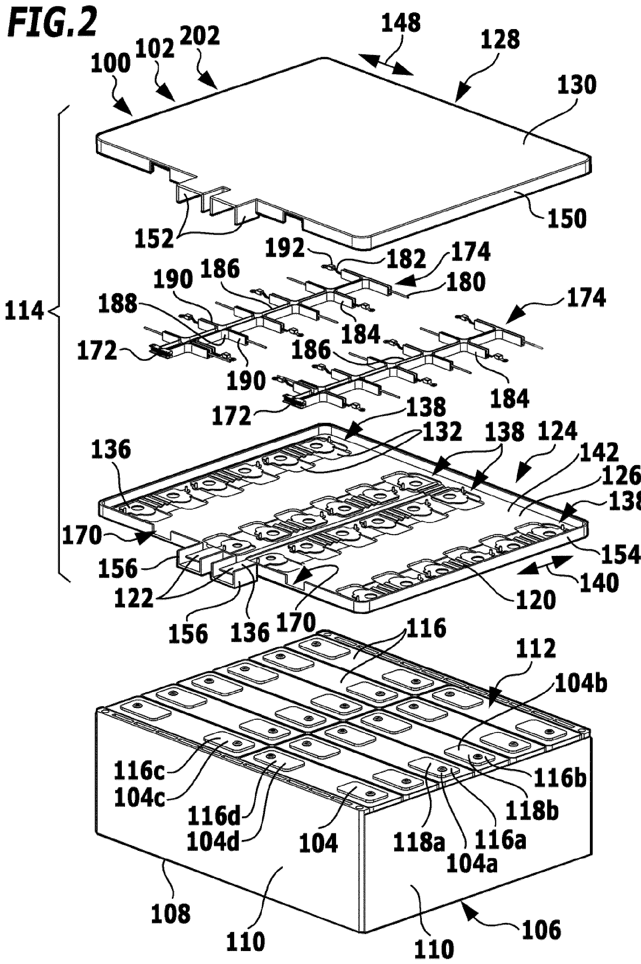

Eine als Ganzes mit 100 bezeichnete elektrochemische Vorrichtung umfasst beispielsweise mehrere elektrochemische Module 102, von denen jedes mehrere, im dargestellten Ausführungsbeispiel zwölf, elektrochemische Zellen 104 umfasst, welche nebeneinander in einem Gehäuse 106 des elektrochemischen Moduls 102 angeordnet sind (siehe die Fig. 1 und 2).

Das Gehäuse 106 kann beispielsweise im Wesentlichen quaderförmig ausgebildet sein und eine Bodenwand 108 und sich von der Bodenwand 108 weg erstreckende Seitenwände 110 umfassen, deren der Bodenwand 108 abgewandte Ränder eine Gehäuseöffnung 112 umgeben, die mittels eines Deckels 114 verschließbar ist.

Die elektrochemischen Zellen 104 sind in dem Gehäuse 106 des elektrochemischen Moduls 102 so angeordnet und ausgerichtet, dass die beiden Zellterminals 116 jeder elektrochemischen Zelle 104 auf der dem Deckel 114 zugewandten Seite der jeweiligen elektrochemischen Zelle 104 angeordnet sind.

Bei jeder elektrochemischen Zelle 104 bildet eines der Zellterminals 116 einen negativen Pol 118a und das jeweils andere Zellterminal 116 einen positiven Pol 118b der betreffenden elektrochemischen Zelle 104.

Die elektrochemische Vorrichtung 100 kann insbesondere als ein Akkumulator, insbesondere als ein Lithium-Ionen-Akkumulator, beispielsweise des Typs LiFePO₄, ausgebildet sein.

Die elektrochemischen Module 102 können entsprechend als Akkumulatormodule und die elektrochemischen Zellen 104 als Akkumulatorzellen, insbesondere als Lithium-Ionen-Akkumulatorzellen, beispielsweise vom Typ LiFePO₄, ausgebildet sein.

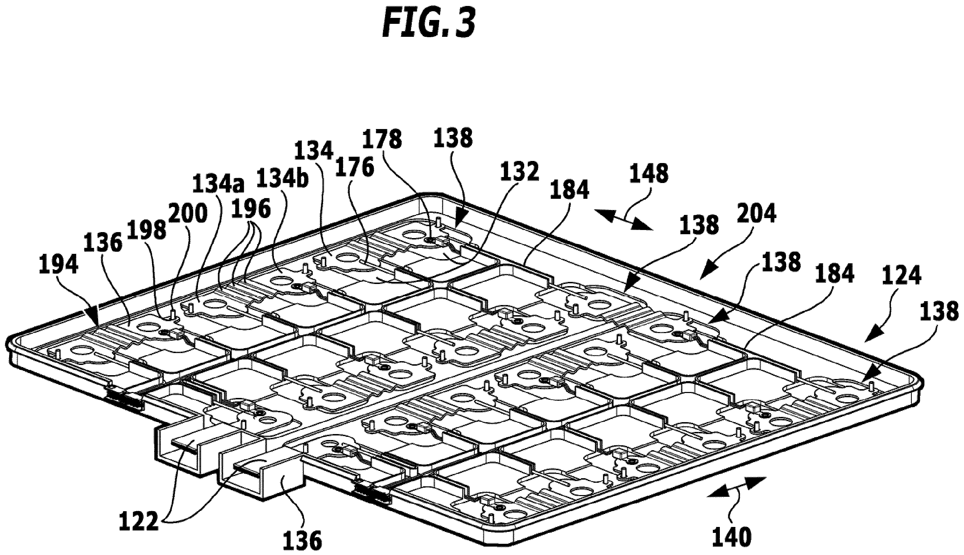

Das elektrochemische Modul 102 umfasst ferner mehrere Zellverbinder 120 (siehe insbesondere die Fig. 2 und 3), mittels welcher die Zellterminals 116 einander benachbarter elektrochemischer Zellen 104 mit unterschiedlicher Polarität elektrisch leitend miteinander verbindbar sind, um auf diese Weise alle elektrochemischen Zellen 104 eines elektrochemischen Moduls 102 elektrisch in Reihe zu schalten.

Dabei verbindet jeder Zellverbinder 120 ein erstes Zellterminal 116a negativer Polarität einer ersten elektrochemischen Zelle 104a mit einem zweiten Zellterminal 116b positiver Polarität einer benachbarten zweiten elektrochemischen Zelle 104b (siehe Fig. 2).

Jeweils ein Zellterminal 116c der den Anfang der Zellen-Reihenschaltung des elektrochemischen Moduls 102 bildenden elektrochemischen Zelle 104c und ein Zellterminal 116d der das Ende der Zellen-Reihenschaltung bildenden elektrochemischen Zelle 104d sind jeweils elektrisch leitend mit einem elektrisch leitenden Stromanschluss 122 des elektrochemischen Moduls 102 verbunden (siehe die Fig. 1 bis 3).

Die mehreren elektrochemischen Module 102 der elektrochemischen Vorrichtung 100 sind vorzugsweise elektrisch in Reihe geschaltet.

Eine solche Reihenschaltung kann insbesondere dadurch hergestellt werden, dass ein elektrischer Stromanschluss 120 eines ersten elektrochemischen Moduls mittels eines (nicht dargestellten) Modulverbinders elektrisch leitend mit einem elektrischen Stromanschluss 120 (entgegengesetzter Polarität) eines zweiten elektrochemischen Moduls verbunden wird.

Der auf das Gehäuse 106 aufsetzbare und im montierten Zustand die Gehäuseöffnung 112 verschließende Deckel 114 ist im Einzelnen in den Fig. 2 und 3 dargestellt.

Der Deckel 114 umfasst ein Trägerelement 124, beispielsweise in Form einer vorzugsweise im Wesentlichen rechteckigen Trägerplatte 126, und ein an dem Trägerelement 124 gehaltenes Abdeckelement 128, beispielsweise in Form einer, vorzugsweise im Wesentlichen rechteckigen, Abdeckplatte 130.

Wie am Besten aus Fig. 3 zu ersehen ist, ist das Trägerelement 124 mit einer Mehrzahl von Durchtrittsöffnungen 132 versehen, wobei jede Zugangsöffnung 132 jeweils einem Kontaktbereich 134 eines Funktionselements 136 der elektrochemischen Vorrichtung 100, insbesondere des elektrochemischen Moduls 102, insbesondere jeweils einem Kontaktbereich 134 eines Zellverbinders 120 oder eines Stromanschlusses 122, und jeweils einem Zellterminal 116 der elektrochemischen Zellen 104 der elektrochemischen Vorrichtung 100, insbesondere des elektrochemischen Moduls 102, zugeordnet ist, so dass durch eine solche Durchtrittsöffnung 132 jeweils ein Zellterminal 116 mit einem zugeordneten Kontaktbereich 134 eines Funktionselements 136 verbindbar ist.

Dabei kann sich beispielsweise ein Zellterminal 116 durch die Durchtrittsöffnung 132 hindurch erstrecken, um in Kontakt mit einem Kontaktbereich 134 eines Funktionselements 136 zu kommen.

Alternativ hierzu kann sich auch ein Kontaktbereich 134 eines Funktionselements 136 durch die jeweils zugeordnete Durchtrittsöffnung 132 hindurch erstrecken, um in Kontakt mit dem jeweils zugeordneten Zellterminal 116 zu kommen.

Ferner ist auch denkbar, dass sich sowohl das Zellterminal 116 als auch der Kontaktbereich 134 des Funktionselements 136 beide in die Durchtrittsöffnung 132 hinein erstrecken und dort miteinander verbunden sind.

Wie aus den Fig. 2 und 3 zu ersehen ist, können die Durchtrittsöffnungen 132 des Trägerelements 124 in mehreren Reihen 138 angeordnet sein, wobei die Reihen 138 sich beispielsweise in einer Längsrichtung 140 des Trägerelements 124 erstrecken.

Die Durchtrittsöffnungen 132 können insbesondere im Wesentlichen rechteckig ausgebildet sein; grundsätzlich sind aber auch andere Formen der Durchtrittsöffnungen, insbesondere kreisförmige, ovale, quadratische oder polygonale, Durchtrittsöffnungen 132 möglich.

An der im montierten Zustand des Deckels 114 den elektrochemischen Zellen 104 abgewandten Außenseite 142 des Trägerelements 124 ist das Abdeckelement 128 angeordnet, welches zum Abdecken der Funktionselemente 136, insbesondere der Zellverbinder 120 und der Stromanschlüsse 122, dient.

Das Abdeckelement 128 ist beispielsweise als ein Tiefziehteil oder ein Spritzgießteil ausgebildet.

Das Abdeckelement umfasst vorzugsweise ein thermoplastisches Material, insbesondere Polypropylen.

Vorzugsweise ist das Abdeckelement im Wesentlichen vollständig aus einem thermoplastischen Material, insbesondere aus Polypropylen, gebildet.

Wie aus den Fig. 1 und 2 zu ersehen ist, ist das Abdeckelement 128 ferner vorzugsweise mit einem längs seines äußeren Randes umlaufenden, im montierten Zustand des Deckels 114 zu dem Trägerelement 124 hin vorstehenden Randbereich 150 versehen.

Der Randbereich 150 kann von zwei Durchtrittskanälen 152 unterbrochen sein, welche vom Rand des Abdeckelements 128, beispielsweise in der Längsrichtung 140, nach außen vorstehen und beispielsweise einen im Wesentlichen U-förmigen Querschnitt aufweisen können.

Wie am Besten aus Fig. 2 zu ersehen ist, ist auch das Trägerelement 124 vorzugsweise mit einem längs seines äußeren Randes umlaufenden, im montierten Zustand des Deckels 114 zu dem Abdeckelement 128 hin vorstehenden Randbereich 154 versehen.

Auch der Randbereich 154 des Trägerelements 124 kann von zwei Durchtrittskanälen 156 unterbrochen sein, welche vom Rand des Trägerelements 124, vorzugsweise in der Längsrichtung 140, nach außen vorstehen und beispielsweise einen im Wesentlichen U-förmigen Querschnitt aufweisen können.

Die Durchtrittskanäle 156 des Trägerelements 124 und die Durchtrittskanäle 152 des Abdeckelements 128 sind an einander entsprechenden Stellen der jeweiligen Randbereiche 154 bzw. 150 angeordnet und mit ihren offenen Seiten einander zugewandt, so dass die Durchtrittskanäle 156, 152 zusammen einen Durchtrittsschacht 158 bilden, welcher zur Aufnahme jeweils eines der Stromanschlüsse 122 des elektrochemischen Moduls 102 dient.

Jeder Stromanschluss 122 ist dabei im montierten Zustand des elektrochemischen Moduls 102 mit einem Zellterminal 116c der ersten elektrochemischen Zelle 104c der Reihenschaltung des elektrochemischen Moduls 102 bzw. mit einem Zellterminal 116d der letzten elektrochemischen Zelle 104d der Reihenschaltung des elektrochemischen Moduls 102 verbunden.

Um das Abdeckelement 128 lösbar an dem Trägerelement 124 festlegen zu können, ist vorzugsweise eine (nicht dargestellte) Rastvorrichtung vorgesehen, welche ein oder mehrere an dem Abdeckelement 128 vorgesehene Rastelemente und ein oder mehrere an dem Trägerelement 124 vorgesehene Rastelemente umfasst.

Das trägerelementseitige Rastelement kann beispielsweise als ein an dem dem Abdeckelement 128 zugewandten Rand des Randbereichs 154 des Trägerelements 124 umlaufender, nach außen vorspringender Rastwulst ausgebildet sein.

Die abdeckelementseitigen Rastelemente können beispielsweise als mehrere in der Umfangsrichtung des Abdeckelements 128 aufeinanderfolgende, von dem Randbereich 150 des Abdeckelements 128 nach innen vorspringende Rastvorsprünge ausgebildet sein.

Wenn das Abdeckelement 128 von oben auf das Trägerelement 124 aufgesetzt wird, gelangen die Rastvorsprünge unter elastischer Verformung des Randbereichs 150 des Abdeckelements 128 und/oder des Rastwulstes des Trägerelements 124 an dem Rastwulst vorbei und rasten unterhalb des Rastwulstes ein, so dass das Abdeckelement 128 durch Verrastung an dem Trägerelement 124 gesichert ist.

Selbstverständlich können die Rastelemente am Abdeckelement 128 und die Rastelemente am Trägerelement 124 auch in jeder beliebigen anderen Weise ausgebildet sein, sofern sie nur eine gegenseitige Verrastung von Abdeckelement 128 und Trägerelement 124 ermöglichen.

Die Rastelemente 162 des Abdeckelements 128 können in das Abdeckelement 128 eingeformt oder eingeprägt oder an das Abdeckelement 128 eingeformt sein.

Das Trägerelement 124 ist in seinem Randbereich 154 vorzugsweise mit einer oder mehreren Ausnehmungen 170 zur Aufnahme jeweils eines, vorzugsweise mehrpoligen, Steckers 172 versehen.

Jeder Stecker 172 dient zum Anschließen eines an dem Trägerelement 124 angeordneten Leitungssystems 174 an eine (nicht dargestellte) Überwachungseinheit der elektrochemischen Vorrichtung 100 über eine (nicht dargestellte), vorzugsweise mehrpolige, Verbindungsleitung.

Bei der in den Figuren dargestellten Ausführungsform eines elektrochemischen Moduls 102 sind zwei solche Leitungssysteme 174 vorhanden.

Jedes der Leitungssysteme 174 dient zum Verbinden einer Mehrzahl von Spannungsabgriffstellen 176 und einer Mehrzahl von Temperaturmessstellen 178 des elektrochemischen Moduls 102 mit der (nicht dargestellten) Überwachungseinheit der elektrochemischen Vorrichtung 100.

Jedes Leitungssystem 174 umfasst mehrere Spannungsabgriffsleitungen 180, welche von jeweils einer Spannungsabgriffstelle 176 zu dem Stecker 172 des Leitungssystems 174 führen, und mehrere Temperaturmessleitungen 182, welche von jeweils einer Temperaturmessstelle 178 zu dem Stecker 172 des Leitungssystems 174 führen, sowie eine Versteifungsstruktur 184, an welcher die Spannungsabgriffsleitungen 180 und die Temperaturmessleitungen 182 zumindest abschnittsweise angeordnet sind.

Die Versteifungsstruktur 184 jedes Leitungssystems 174 ist vorzugsweise baumartig aufgebaut und umfasst einen Hauptaufnahmekanal 168, welcher sich beispielsweise in der Längsrichtung 140 des Deckels 114 erstreckt, und mehrere an Verzweigungsstellen 188 von dem Hauptaufnahmekanal 168 abzweigende Nebenaufnahmekanäle 190.

Dabei ist insbesondere vorgesehen, dass der Hauptaufnahmekanal 186 mehrere Spannungsabgriffsleitungen 180 und Temperaturmessleitungen 182 des Leitungssystems 174 aufnimmt, während vorzugsweise jeder der Nebenaufnahmekanäle 190 jeweils nur eine Spannungsabgriffsleitung 180 und/oder nur eine Temperaturmessleitung 182 aufnimmt.

Der Hauptaufnahmekanal 186 und/oder die Nebenaufnahmekanäle 190 weisen vorzugsweise einen im Wesentlichen U-förmigen Querschnitt auf, der sich zu der dem Trägerelement 124 abgewandten Seite der Versteifungsstruktur 184 hin öffnet, so dass die Spannungsabgriffsleitungen 180 und die Temperaturmessleitungen 182 von dieser Seite her in die Versteifungsstruktur 184 eingebracht werden können.

Die Versteifungsstruktur 184 ist vorzugsweise einstückig ausgebildet und kann insbesondere ein spritzgießfähiges Material, beispielsweise PBT (Polybutylenterephthalat), PP (Polypropylen), PA (Polyamid), ABS (Acrylnitril-Butadien-Styrol) und/oder LCP ("Liquid Crystal Polymer") umfassen.

Alternativ oder ergänzend hierzu kann auch vorgesehen sein, dass die Versteifungsstruktur 184 ein metallisches Material, beispielsweise Aluminium, umfasst und insbesondere als ein metallisches Umformteil, beispielsweise ein Stanz-Biege-Teil, ausgebildet ist.

Die Versteifungsstruktur 184 kann eine oder mehrere Halteeinrichtungen umfassen, durch welche die Spannungsabgriffsleitungen 180 und die Temperaturmessleitungen 182, vorzugsweise lösbar, an der Versteifungsstruktur 184 festgelegt sind.

Solche Halteeinrichtungen können beispielsweise als Haken, Klammern, Rastelemente, Clipse oder Ähnliches ausgebildet sein, welche an der Versteifungsstruktur 184 und/oder an den Leitungen 180 oder 182 angeordnet sind.

Jede Versteifungsstruktur 184 eines Leitungssystems 174 kann wiederum als Ganzes, insbesondere lösbar, an der im montierten Zustand des Deckels 114 dem Abdeckelement 128 zugewandten Außenseite 142 des Trägerelements 124 festgelegt sein.

Die Festlegung der Versteifungsstruktur 184 an dem Trägerelement 124 kann beispielsweise durch Verrastung, Verschweißung und/oder Verklebung erfolgen.

Das Ende jeder Spannungsabgriffsleitung 180 ist elektrisch leitend an jeweils einen Kontaktbereich 134 eines Zellverbinders 120 oder eines Stromanschlusses 122 des elektrochemischen Moduls 102 angeschlossen, um das dort jeweils herrschende elektrische Potential abgreifen zu können.

Das Ende jeder Temperaturmessleitung 182 ist an jeweils einen Temperatursensor 192, beispielsweise in Form eines NTC-Elements ("Negative Temperature Coefficient"), angeschlossen. Jeder Temperatursensor 194 steht ebenfalls in Kontakt mit einem Kontaktbereich 134 eines Zellverbinders 120 oder mit einem Stromanschluss 122 des elektrochemischen Moduls 102, um die dort herrschende Temperatur messen zu können.

Jeder der Kontaktbereiche 134 der Zellverbinder 120 und jeder Stromanschluss 122 ist jeweils einem Zellterminal 114 des elektrochemischen Moduls 102 zugeordnet und im montierten Zustand des elektrochemischen Moduls 102 elektrisch leitend, vorzugsweise stoffschlüssig, mit dem jeweils zugeordneten Zellterminal 114 verbunden.

Jeder Zellverbinder 120 umfasst zwei Kontaktbereiche 134a und 134b zum elektrischen Kontaktieren von jeweils einem Zellterminal 114 und einen die beiden Kontaktbereiche 134a und 134b miteinander verbindenden Kompensationsbereich 194. Der Kompensationsbereich 194 ist vorzugsweise elastisch und/oder plastisch verformbar, um eine Relativbewegung der beiden Kontaktbereiche 134a und 134b des Zellverbinders 120 relativ zueinander im Betrieb der elektrochemischen Vorrichtung 100 und/oder zum Toleranzausgleich bei der Montage der elektrochemischen Vorrichtung 100 zu ermöglichen.

Zu diesem Zweck kann der Kompensationsbereich 194 insbesondere ein oder mehrere quer zu einer Verbindungsrichtung, welche ein Zentrum des ersten Kontaktbereichs 134a und ein Zentrum des zweiten Kontaktbereichs 134b des Zellverbinders 120 miteinander verbindet, verlaufende Kompensationswellen 196 aufweisen.

Jeder Kontaktbereich 134 der Zellverbinder 120 und die Stromanschlüsse 122 können mittels jeweils eines Positionierungsloches 198 an einem jeweils zugeordneten Positionierungsstift 200 des Trägerelements 124 positioniert sein.

Dabei durchsetzt vorzugsweise der Positionierungsstift 200 des Trägerelements 124 das jeweils zugeordnete Positionierungsloch 198 des Zellverbinders 120 bzw. des Stromanschlusses 122.

Der Deckel 114 des elektrochemischen Moduls 102, welcher das Trägerelement 124 einschließlich der Leitungssysteme 174 und der Funktionselemente 136 sowie das Abdeckelement 128 umfasst, bildet ein Zellkontaktierungssytem 202 zur Kontaktierung und Überwachung der elektrochemischen Zellen 104 des elektrochemischen Moduls 102.

Das Trägerelement 124 und/oder das Abdeckelement 128 umfasst vorzugsweise ein elektrisch nicht leitendes Kunststoffmaterial, beispielsweise PBT, PP, PA, ABS und/oder LCP, und ist vorzugsweise im Wesentlichen vollständig aus einem solchen Kunststoffmaterial gebildet.

Ein besonders geeignetes Material für das Trägerelement 124 und/oder das Abdeckelement 128 ist ein mit Talkum verstärktes Polypropylen-Material (beispielsweise das Material mit der Bezeichnung PP TV20). Dieses Material weist durch die Talkumverstärkung eine besonders hohe Formstabilität auf.

Das Trägerelement 124 und die Leitungssysteme 174 sowie die Zellverbinder 120 und Stromanschlüsse 122 werden vorzugsweise als separate Baugruppe 204 komplett vormontiert.

Bei dieser Vormontage werden die Zellverbinder 120 und Stromanschlüsse 122 an dem Trägerelement 124 positioniert, und die Spannungsabgriffsleitungen 180 und Temperaturmessleitungen 182 werden mit den Zellverbindern 120 und den Stromanschlüssen 122 sowie mit den Steckern 172 verbunden und an den Versteifungsstrukturen 184 der Leitungssysteme 174, vorzugsweise lösbar, festgelegt.

Wenn die Versteifungsstrukturen 184 nicht ohnehin bereits mit dem Trägerelement 124 verbunden sind, werden ferner die Versteifungsstrukturen 184 an der Außenseite 142 des Trägerelements 124 festgelegt.

Somit sind alle für die Kontaktierung der elektrochemischen Zellen 104 eines elektrochemischen Moduls 102 benötigten Bauteile in einer als Einheit handhabbaren Baugruppe 204, bereits in der erforderlichen relativen Positionierung, zusammengefasst.

Die Zellverbinder 120, die Stromanschlüsse 122 und/oder die Versteifungsstrukturen 184 der Leitungssysteme 174 können insbesondere durch Verrastung, Verschweißung und/oder Verklipsung an dem Trägerelement 124 festgelegt sein.

Das Trägerelement 124 des Deckels 114 wird bei der Montage eines elektrochemischen Moduls 102 auf das Gehäuse 106 aufgesetzt, in welchem die elektrochemischen Zellen 104 angeordnet sind, und mit dem die Gehäuseöffnung 110 umgebenden Rand des Gehäuses 106 verbunden.

Anschließend werden die Funktionselemente 136, insbesondere die Zellverbinder 120 und die Stromanschlüsse 122, elektrisch leitend mit den jeweils zugeordneten Zellterminals 114 des elektrochemischen Moduls 102 kontaktiert, beispielsweise durch Verschweißung, insbesondere mittels eines Lasers, und zwar durch die bei noch nicht aufgesetztem Abdeckelement 128 frei zugänglichen Durchtrittsöffnungen 132 des Trägerelements 124 hindurch.

Nach erfolgter Kontaktierung zwischen den Funktionselementen 136 und den Zellterminals 116 der elektrochemischen Zellen 104 des elektrochemischen Moduls 102 wird das Abdeckelement 128 auf das Trägerelement 124 aufgesetzt und mit demselben verbunden, insbesondere durch Verrastung, so dass das Abdeckelement 128 die Funktionselemente 136 und die Durchtrittsöffnungen 132 des Trägerelements 124 sowie die Leitungssysteme 174 abdeckt und vor einer ungewollten Berührung schützt.

Hierdurch wird eine Beschädigung des Zellkontaktierungssystems 202 während des Transports und der Montage des elektrochemischen Moduls 102 verhindert.

Das fertig montierte elektrochemische Modul 102 kann mit mehreren anderen elektrochemischen Modulen 102 zu der elektrochemischen Vorrichtung 100 zusammengesetzt werden, wobei insbesondere verschiedene elektrochemische Module 102 mittels (nicht dargestellter) Modulverbinder, welche die Stromanschlüsse 122 verschiedener elektrochemischer Module 102 miteinander verbinden, zusammengeschaltet werden können.

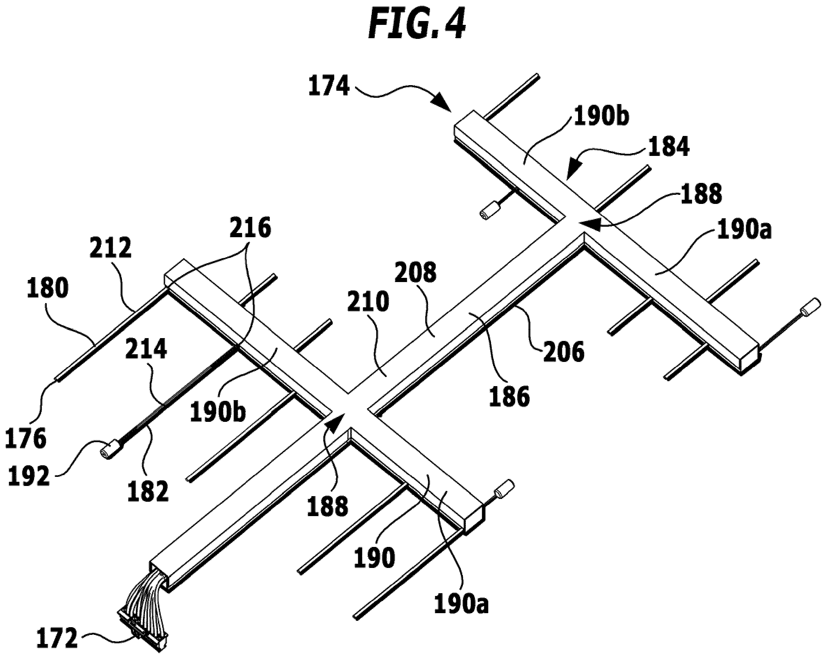

Eine in Fig. 4 dargestellte zweite Ausführungsform eines Leitungssystems unterscheidet sich von der in den Fig. 1 bis 3 dargestellten ersten Ausführungsform dadurch, dass die Versteifungsstruktur 184 nicht zu einer Seite hin offen, sondern um die Spannungsabgriffsleitungen 180 und Temperaturmessleitungen 182 herum geschlossen ausgebildet ist.

Insbesondere kann die Versteifungsstruktur 184 ein Unterteil 206 umfassen, welches einen Boden des Hauptaufnahmekanals 186 und der Nebenaufnahmekanäle 190 der Versteifungsstruktur 184 bildet, und ein Oberteil 208, welches als ein Verschlussdeckel 210 auf dem Unterteil 206 angeordnet ist und den Hauptaufnahmekanal 186 und die Nebenaufnahmekanäle 190 der Versteifungsstruktur 184 auf der dem Unterteil 206 abgewandten Seite verschließt.

Das Unterteil 206 und das Oberteil 208 können beispielsweise in jedem Abschnitt des Hauptaufnahmekanals 186 und der Nebenaufnahmekanäle 190 einen U-förmigen Querschnitt aufweisen, wobei die offenen Seiten dieser U-förmigen Querschnitte des Unterteils 206 und des Oberteils 208 einander zugewandt sind.

Ferner kann vorgesehen sein, dass das Unterteil 206 und das Oberteil 208, vorzugsweise lösbar, aneinander festgelegt sind, beispielsweise durch Verrastung oder durch stoffschlüssige Verbindung, insbesondere durch Verschweißung.

Das Unterteil 206 und das Oberteil 208 der Versteifungsstruktur 184 können aus denselben Materialien gebildet sein wie die Versteifungsstruktur 184 der in den Fig. 1 bis 3 dargestellten Ausführungsform.

Das Unterteil 206 und/oder das Oberteil 208 können als Spritzgießteil ausgebildet sein.

Jede Spannungsabgriffsleitung 180 des Leitungssystems 174 umfasst einen Messstellenabschnitt 212, welcher außerhalb der Versteifungsstruktur 184 von der jeweiligen Spannungsabgriffstelle 176 bis zur Wandung der Versteifungsstruktur 184 verläuft, und einen innerhalb der Versteifungsstruktur 184 bis zu dem jeweiligen Stecker 172 verlaufenden gestützten Abschnitt.

Ebenso umfassen die Temperaturmessleitungen 182 des Leitungssystems 174 jeweils einen außerhalb der Versteifungsstruktur 184 angeordneten Messstellenabschnitt 214, der von dem jeweils zugeordneten Temperatursensor 192 bis zur Wandung der Versteifungsstruktur 184 verläuft, und einen innerhalb der Versteifungsstruktur 184 zu dem jeweiligen Stecker 172 verlaufenden gestützten Abschnitt.

Die Messstellenabschnitte 212 der Spannungsabgriffsleitungen 180 und die Messstellenabschnitte 214 der Temperaturmessleitungen 182 treten durch in der Wandung der Versteifungsstruktur 184 vorgesehene Ausnehmungen 216 aus der Versteifungsstruktur 184 heraus.

Vorzugsweise treten die Messstellenabschnitte 212 und 214 aus den Nebenaufnahmekanälen 190 der Versteifungsstruktur 184 heraus.

Die Spannungsabgriffsleitung 180 und die Temperaturmessleitung 182 sind mittels einer oder mehreren Halteeinrichtungen, vorzugsweise lösbar, am Unterteil 206 und/oder am Oberteil 208 der Versteifungsstruktur 184 festgelegt.

Wenn alle Spannungsabgriffsleitungen und Temperaturmessleitungen 182 am Unterteil 206 der Versteifungsstruktur 184 festgelegt sind, kann das Oberteil 208 der Versteifungsstruktur 184 nach dem Verbinden der Spannungsabgriffsleitungen 180 und der Temperaturmessleitungen 182 mit den Funktionselementen 136 der elektrochemischen Vorrichtung 100 entfernt werden; in diesem Fall dient das Oberteil 208 nur als Montagehilfe und ist in der einsatzbereiten elektrochemischen Vorrichtung 100 nicht mehr vorhanden.

Wenn alle Spannungsabgriffsleitungen 180 und Temperaturmessleitungen 182 an dem Oberteil 208 der Versteifungsstruktur 184 festgelegt sind, kann das Unterteil 206 nach dem Verbinden der Spannungsabgriffsleitungen 180 und der Temperaturmessleitungen 182 mit den Funktionselementen 136 der elektrochemischen Vorrichtung 100 entfernt werden; in diesem Fall dient das Unterteil 206 nur als Montagehilfe und ist in der einsatzbereiten elektrochemischen Vorrichtung 100 nicht mehr vorhanden.

Grundsätzlich ist auch denkbar, dass die gesamte Versteifungsstruktur 184 nur als Montagehilfe dient und insgesamt nach dem Verbinden der Spannungsabgriffsleitungen 180 und der Temperaturmessleitungen 182 mit den Funktionselementen 136 der elektrochemischen Vorrichtung 100 entfernt wird, so dass die Versteifungsstruktur 184 in der einsatzbereiten elektrochemischen Vorrichtung 100 nicht mehr vorhanden ist.

Die in Fig. 4 dargestellte zweite Ausführungsform eines Leitungssystems 174 ist beispielhaft so ausgebildet, dass sich an den Verzweigungsstellen 188 der Versteifungsstruktur 184 jeweils zwei Nebenaufnahmekanäle 190, und zwar vorzugsweise in einander entgegengesetzte Richtungen, von dem Hauptaufnahmekanal 186 der Versteifungsstruktur 184 weg erstrecken.

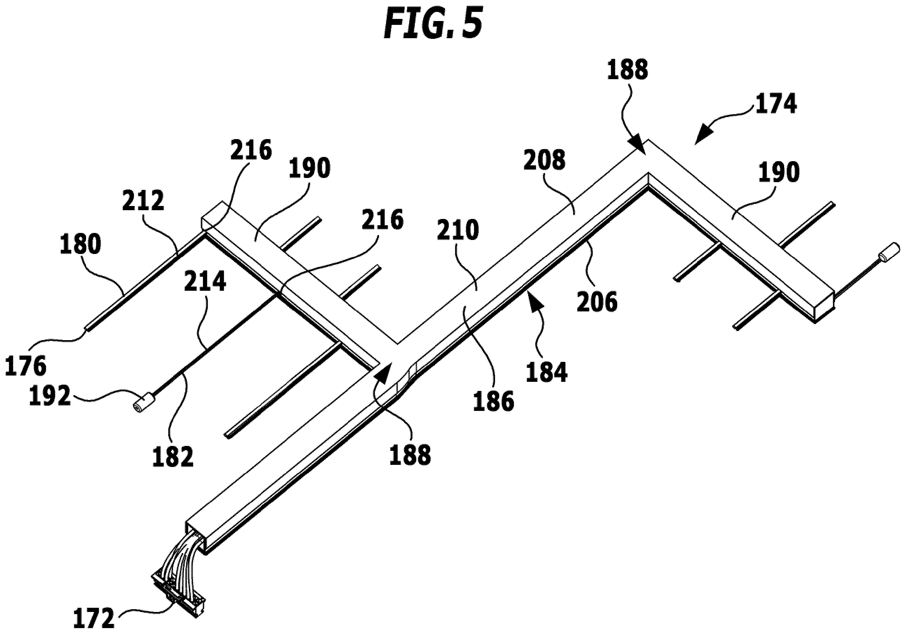

Eine in Fig. 5 dargestellte dritte Ausführungsform eines Leitungssystems 174 unterscheidet sich von der in Fig. 4 dargestellten zweiten Ausführungsform dadurch, dass an den Verzweigungsstellen 188 nur jeweils ein Nebenaufnahmekanal 190 von dem Hauptaufnahmekanal 186 der Versteifungsstruktur 184 abzweigt.

Grundsätzlich können aber an jeder Verzweigungsstelle 188 der Versteifungsstruktur 184 beliebig viele Nebenaufnahmekanäle 190 von dem Hauptaufnahmekanal 186 abzweigen, und zwar in grundsätzlich beliebige Richtungen, und es ist auch möglich, die Versteifungsstruktur 184 so auszubilden, dass auch ein oder mehrere Nebenaufnahmekanäle 190 ihrerseits wieder in einen oder mehrere Unter-Nebenaufnahmekanäle verzweigen.

Im Übrigen stimmen die in den Fig. 4 und 5 dargestellten Leitungssysteme 174 hinsichtlich Aufbau, Herstellungsweise und Funktion mit der in den Fig. 1 bis 3 dargestellten ersten Ausführungsform überein, auf deren vorstehende Beschreibung insoweit Bezug genommen wird.

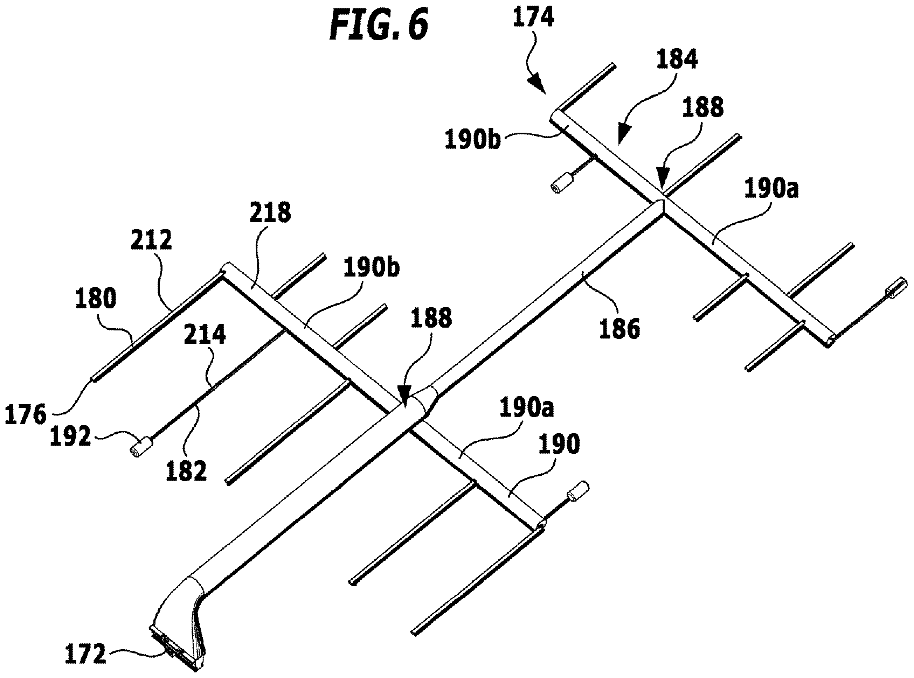

Eine in Fig. 6 dargestellte vierte Ausführungsform eines Leitungssystems 174 unterscheidet sich von der in Fig. 4 dargestellten zweiten Ausführungsform dadurch, dass die Versteifungsstruktur 184 nicht getrennt von den Spannungsabgriffsleitungen 180 und den Temperaturmessleitungen 182 hergestellt und erst danach mit diesen Leitungen verbunden worden ist, sondern dass die Spannungsabgriffsleitungen 180 und die Temperaturmessleitungen 182 des Leitungssystems 174 in der gewünschten relativen Positionierung und Ausrichtung angeordnet und dann Abschnitte der Spannungsabgriffsleitungen 180 und der Temperaturmessleitungen 182 mit einer Umhüllung 218 versehen worden sind, welche diese Abschnitte der genannten Leitungen einschließt und hierdurch eine formstabile Versteifungsstruktur 184 des Leitungssystems 174 bildet.

Das Material der Umhüllung 218 kann insbesondere ein Kunststoffmaterial, insbesondere ein Elastomermaterial, umfassen.

Vorzugsweise ist die Umhüllung 218 im Wesentlichen vollständig aus einem Kunststoffmaterial, insbesondere aus einem Elastomermaterial, gebildet.

Die Umhüllung 218 kann insbesondere durch Umspritzen an die Spannungsabgriffsleitungen 180 und die Temperaturmessleitungen 182 angeformt sein. Auch bei dieser Ausführungsform weist die Versteifungsstruktur 184 des Leitungssystems 174 Formstabilität auf; die Versteifungsstruktur 184 ist aber vorzugsweise plastisch und/oder elastisch verformbar, was die Handhabung des Leitungssystems 174 bei der Montage der elektrochemischen Vorrichtung 100 erleichtern kann.

Im Übrigen stimmt die in Fig. 6 dargestellte vierte Ausführungsform eines Leitungssystems 174 hinsichtlich Aufbau, Herstellungsweise und Funktion mit der in Fig. 4 dargestellten zweiten Ausführungsform überein, auf deren vorstehende Beschreibung insoweit Bezug genommen wird.

## Patentansprüche

1. Elektrochemische Vorrichtung, die mehrere elektrochemische Zellen (104) und mindestens ein Leitungssystem (174) zum Verbinden einer Mehrzahl von Spannungsabgriffstellen (176) und/oder Temperaturmessstellen (178) einer elektrochemischen Vorrichtung (100) mit einer Überwachungseinheit der elektrochemischen Vorrichtung (100) umfasst, wobei das Leitungssystem (174)
mehrere Spannungsabgriffsleitungen (180) und/oder Temperaturmessleitungen (182) und
eine Versteifungsstruktur (184), in welcher und/oder an welcher die mehreren Spannungsabgriffsleitungen (180) und/oder Temperaturmessleitungen (182) zumindest abschnittsweise angeordnet sind, umfasst,
wobei die Versteifungsstruktur (184) mindestens einen Aufnahmekanal zum Einlegen mindestens einer Spannungsabgriffsleitung (180) und/oder mindestens einer Temperaturmessleitung (182) umfasst,
wobei die elektrochemische Vorrichtung (100) einen Deckel (114) umfasst, der ein den elektrochemischen Zellen (104) der elektrochemischen Vorrichtung (100) zugewandtes Trägerelement (124) und ein den elektrochemischen Zellen (104) der elektrochemischen Vorrichtung (100) abgewandtes Abdeckelement (128) umfasst, und
wobei das Leitungssystem (174) zwischen dem Trägerelement (124) und dem Abdeckelement (128) angeordnet ist,
**dadurch gekennzeichnet,**
**dass** die Versteifungsstruktur (184) separat von dem Trägerelement (124) hergestellt und an dem Trägerelement (124) festgelegt ist.

2. Elektrochemische Vorrichtung nach Anspruch 1, **dadurch gekennzeichnet, dass** mindestens eine der Spannungsabgriffsleitungen (180) und/oder mindestens eine der Temperaturmessleitungen (182) einen Messstellenabschnitt (212, 214) umfasst, der an eine Spannungsabgriffstelle (176) oder an eine Temperaturmessstelle (178) anschließbar ist und außerhalb der Versteifungsstruktur (184) angeordnet ist.

3. Elektrochemische Vorrichtung nach einem der Ansprüche 1 oder 2, **dadurch gekennzeichnet, dass** das Leitungssystem (174) einen mehrpoligen Stecker (172) umfasst, der mit mehreren Spannungsabgriffsleitungen (180) und/oder Temperaturmessleitungen (182) des Leitungssystems (174) verbunden ist und an den eine zu der Überwachungseinheit führende Verbindungsleitung anschließbar ist.

4. Elektrochemische Vorrichtung nach einem der Ansprüche 1 bis 3, **dadurch gekennzeichnet, dass** das Leitungssystem (174) mindestens einen Temperatursensor (192) umfasst.

5. Elektrochemische Vorrichtung nach einem der Ansprüche 1 bis 4, **dadurch gekennzeichnet, dass** die Versteifungsstruktur (184) lösbar mit den Spannungsabgriffsleitungen (180) und/oder den Temperaturmessleitungen (182) des Leitungssystems (174) verbunden ist.

6. Elektrochemische Vorrichtung nach einem der Ansprüche 1 bis 5, **dadurch gekennzeichnet, dass** die Versteifungsstruktur (184) mindestens eine Verzweigungsstelle (188) umfasst, an welcher zwei oder mehrere Aufnahmekanäle miteinander verbunden sind.

7. Elektrochemische Vorrichtung nach einem der Ansprüche 1 bis 6, **dadurch gekennzeichnet, dass** das Leitungssystem (174) einen Verschlussdeckel (210) zum zumindest teilweisen Verschließen zumindest eines Aufnahmekanals der Versteifungsstruktur (184) umfasst.

8. Elektrochemische Vorrichtung nach einem der Ansprüche 1 bis 7, **dadurch gekennzeichnet, dass** das Leitungssystem (174) mindestens eine Halteeinrichtung umfasst, durch welche mindestens eine Spannungsabgriffsleitung (180) und/oder mindestens eine Temperaturmessleitung (182) an der Versteifungsstruktur (184) festlegbar ist.

9. Elektrochemische Vorrichtung nach einem der Ansprüche 1 bis 8, **dadurch gekennzeichnet, dass** die Versteifungsstruktur (184) ein spritzgießfähiges Material umfasst.

10. Elektrochemische Vorrichtung nach einem der Ansprüche 1 bis 9, **dadurch gekennzeichnet, dass** die Versteifungsstruktur (184) ein metallisches Umformteil umfasst.

11. Elektrochemische Vorrichtung nach einem der Ansprüche 1 bis 10, **dadurch gekennzeichnet, dass** die elektrochemische Vorrichtung (100) ferner mindestens einen Zellverbinder (120) zum elektrisch leitenden Verbinden eines ersten Zellterminals (116a) einer ersten elektrochemischen Zelle (104a) und eines zweiten Zellterminals (116b) einer zweiten elektrochemischen Zelle (104b) umfasst, wobei mindestens eine Spannungsabgriffsleitung (180) und/oder mindestens eine Temperaturmessleitung (182) des Leitungssystems (174) mit mindestens einem Zellverbinder (120) verbunden ist.

12. Elektrochemische Vorrichtung nach einem der Ansprüche 1 bis 11, **dadurch gekennzeichnet, dass** das Abdeckelement (128) lösbar an dem Trägerelement (124) festlegbar ist.

13. Elektrochemische Vorrichtung nach einem der Ansprüche 1 bis 12, **dadurch gekennzeichnet, dass** das Abdeckelement (128) durch Verrastung an dem Trägerelement (124) gesichert ist.

14. Elektrochemische Vorrichtung nach einem der Ansprüche 1 bis 13, **dadurch gekennzeichnet, dass** das Leitungssystem (174) durch eine Haltevorrichtung an dem Trägerelement (124) festlegbar ist.

15. Elektrochemische Vorrichtung nach einem der Ansprüche 1 bis 14, **dadurch gekennzeichnet, dass** mindestens ein Aufnahmekanal einen im Wesentlichen U-förmigen Querschnitt aufweist.

## Claims

1. Electrochemical device which comprises a plurality of electrochemical cells (104) and at least one line system (174) for connecting a plurality of voltage tapping sites (176) and/or temperature measuring sites (178) of an electrochemical device (100) to a monitoring unit of the electrochemical device (100),
wherein the line system (174) comprises
a plurality of voltage tapping lines (180) and/or temperature measuring lines (182) and
a stiffening structure (184) in which and/or on which the plurality of voltage tapping lines (180) and/or temperature measuring lines (182) are at least partially arranged,
wherein the stiffening structure (184) comprises at least one receiving channel for the insertion of at least one voltage tapping line (180) and/or at least one temperature measuring line (182)
wherein the electrochemical device (100) comprises a cover (114) which comprises a support element (124) facing toward the electrochemical cells (104) of the electrochemical device (100) and a lid element (128) facing away from the electrochemical cells (104) of the electrochemical device (100), and
wherein the line system (174) is arranged between the support element (124) and the lid element (128),
**characterized in that**
the stiffening structure (184) is produced separately from the support element (124) and is fixed to the support element (124).

2. Electrochemical device in accordance with Claim 1, **characterized in that** at least one of the voltage tapping lines (180) and/or at least one of the temperature measuring lines (182) comprises a measuring site portion (212, 214) which is connectable to a voltage tapping site (176) or to a temperature measuring site (178) and is arranged outside the stiffening structure (184).

3. Electrochemical device in accordance with either of Claims 1 or 2, **characterized in that** the line system (174) comprises a multi-pole plug connector (172) which is connected to a plurality of voltage tapping lines (180) and/or temperature measuring lines (182) of the line system (174) and to which a connecting line leading to the monitoring unit is connectable.

4. Electrochemical device in accordance with any one of Claims 1 to 3, **characterized in that** the line system (174) comprises at least one temperature sensor (192).

5. Electrochemical device in accordance with any one of Claims 1 to 4, **characterized in that** the stiffening structure (184) is releasably connected to the voltage tapping lines (180) and/or the temperature measuring lines (182) of the line system (174).

6. Electrochemical device in accordance with any one of Claims 1 to 5, **characterized in that** the stiffening structure (184) comprises at least one branching site (188) at which two or more receiving channels are connected to one another.

7. Electrochemical device in accordance with any one of Claims 1 to 6, **characterized in that** the line system (174) comprises a closing cover (210) for at least partial closing of at least one receiving channel of the stiffening structure (184).

8. Electrochemical device in accordance with any one of Claims 1 to 7, **characterized in that** the line system (174) comprises at least one retaining device by means of which at least one voltage tapping line (180) and/or at least one temperature measuring line (182) is fastenable to the stiffening structure (184).

9. Electrochemical device in accordance with any one of Claims 1 to 8, **characterized in that** the stiffening structure (184) comprises an injection mouldable material.

10. Electrochemical device in accordance with any one of Claims 1 to 9, **characterized in that** the stiffening structure (184) comprises a metallic formed part.

11. Electrochemical device in accordance with any one of Claims 1 to 10, **characterized in that** the electrochemical device (100) also comprises at least one cell connector (120) for electrically conductive connection of a first cell terminal (116a) of a first electrochemical cell (104a) and a second cell terminal (116b) of a second electrochemical cell (104b), wherein at least one voltage tapping line (180) and/or at least one temperature measuring line (182) of the line system (174) is connected to at least one cell connector (120).

12. Electrochemical device in accordance with any one of Claims 1 to 11, **characterized in that** the lid element (128) is releasably fastenable to the support element (124).

13. Electrochemical device in accordance with any one of Claims 1 to 12, **characterized in that** the lid element (128) is secured to the support element (124) by latching.

14. Electrochemical device in accordance with any one of Claims 1 to 13, **characterized in that** the line system (174) is fastenable by means of a retaining device to the support element (124).

15. Electrochemical device in accordance with any one of Claims 1 to 14, **characterized in that** at least one receiving channel has a substantially U-shaped cross-section.

## Revendications

1. Dispositif électrochimique qui comprend plusieurs cellules électrochimiques (104) et au moins un système de ligne (174) pour relier une pluralité de points de prise de tension (176) et/ou de points de mesure de la température (178) d'un dispositif électrochimique (100) à un module de surveillance du dispositif électrochimique (100),
dans lequel le système de ligne (174) comprend plusieurs lignes de prise de tension (180) et/ou lignes de mesure de la température (182) et
une structure de rigidification (184) dans laquelle et/ou sur laquelle sont disposées les plusieurs lignes de prise de tension (180) et/ou lignes de mesure de la température (182) au moins par tronçons,
dans lequel la structure de rigidification (184) comprend au moins un canal de réception pour l'insertion d'au moins une ligne de prise de tension (180) et/ou d'au moins une ligne de mesure de la température (182),
dans lequel le dispositif électrochimique (100) comprend un couvercle (114) qui comprend un élément support (124) dirigé vers les cellules électrochimiques (104) du dispositif électrochimique (100) et un élément de recouvrement (128) opposé aux cellules électrochimiques (104) du dispositif électrochimique (100), et
dans lequel le système de ligne (174) est disposé entre l'élément support (124) et l'élément de recouvrement (128),
**caractérisé en ce**
**que** la structure de rigidification (184) est fabriquée séparément de l'élément support (124) et est immobilisée sur l'élément support (124).

2. Dispositif électrochimique selon la revendication 1, **caractérisé en ce qu'**au moins une des lignes de prise de tension (180) et/ou au moins une des lignes de mesure de la température (182) comprend un tronçon de point de mesure (212, 214) pouvant être raccordé à un point de prise de tension (176) ou à un point de mesure de la température (178) et étant disposé à l'extérieur de la structure de rigidification (184) .

3. Dispositif électrochimique selon l'une quelconque des revendications 1 ou 2, **caractérisé en ce que** le système de ligne (174) comprend un connecteur multibroches (172) relié à plusieurs lignes de prise de tension (180) et/ou lignes de mesure de la température (182) du système de ligne (174) et sur lequel une ligne de liaison conduisant au module de surveillance peut être raccordée.

4. Dispositif électrochimique selon l'une quelconque des revendications 1 à 3, **caractérisé en ce que** le système de ligne (174) comprend au moins un capteur de température (192).

5. Dispositif électrochimique selon l'une quelconque des revendications 1 à 4, **caractérisé en ce que** la structure de rigidification (184) est reliée de manière détachable aux lignes de prise de tension (180) et/ou aux lignes de mesure de la température (182) du système de ligne (174).

6. Dispositif électrochimique selon l'une quelconque des revendications 1 à 5, **caractérisé en ce que** la structure de rigidification (184) comprend au moins un point de dérivation (188) sur lequel deux ou plusieurs canaux de réception sont reliés entre eux.

7. Dispositif électrochimique selon l'une quelconque des revendications 1 à 6, **caractérisé en ce que** le système de ligne (174) comprend un couvercle d'obturation (210) pour la fermeture au moins partielle d'au moins un canal de réception de la structure de rigidification (184).

8. Dispositif électrochimique selon l'une quelconque des revendications 1 à 7, **caractérisé en ce que** le système de ligne (174) comprend au moins un dispositif de retenue permettant d'immobiliser au moins une ligne de prise de tension (180) et/ou au moins une ligne de mesure de la température (182) sur la structure de rigidification (184).

9. Dispositif électrochimique selon l'une quelconque des revendications 1 à 8, **caractérisé en ce que** la structure de rigidification (184) comprend une matière moulable à chaud.

10. Dispositif électrochimique selon l'une quelconque des revendications 1 à 9, **caractérisé en ce que** la structure de rigidification (184) comprend une pièce façonnable métallique.

11. Dispositif électrochimique selon l'une quelconque des revendications 1 à 10, **caractérisé en ce que** le dispositif électrochimique (100) comprend, par ailleurs, au moins un connecteur de cellule (120) pour la liaison électriquement conductrice d'un premier terminal cellulaire (116a) d'une première cellule électrochimique (104a) et d'un deuxième terminal cellulaire (116b) d'une deuxième cellule électrochimique (104b), dans lequel au moins une ligne de prise de tension (180) et/ou au moins une ligne de mesure de la température (182) du système de ligne (174) est/sont reliée(s) à au moins un connecteur de cellule (120).

12. Dispositif électrochimique selon l'une quelconque des revendications 1 à 11, **caractérisé en ce que** l'élément de recouvrement (128) peut être immobilisé de manière détachable sur l'élément support (124) .

13. Dispositif électrochimique selon l'une quelconque des revendications 1 à 12, **caractérisé en ce que** l'élément de recouvrement (128) est bloqué sur l'élément support (124) par enclenchement.

14. Dispositif électrochimique selon l'une quelconque des revendications 1 à 13, **caractérisé en ce que** le système de ligne (174) peut être immobilisé sur l'élément support (124) par un dispositif de retenue.

15. Dispositif électrochimique selon l'une quelconque des revendications 1 à 14, **caractérisé en ce qu'**au moins un canal de réception présente une section transversale sensiblement en forme de U.
